Europäisches Patentamt

European Patent Office

Office européen des brevets

(19)

(11) **EP 1 290 792 B1**

(12) **EUROPEAN PATENT SPECIFICATION**

(45) Date of publication and mention
of the grant of the patent:
**01.03.2006 Bulletin 2006/09**

(51) Int Cl.:
*H03H 21/00* (2006.01)    *H04L 25/03* (2006.01)

(21) Application number: **00935187.5**

(22) Date of filing: **07.06.2000**

(86) International application number:
**PCT/EP2000/005268**

(87) International publication number:
**WO 2001/095488 (13.12.2001 Gazette 2001/50)**

(54) **METHOD AND APPARATUS FOR THE EQUALIZATION OF LINEARLY DISTORTED SIGNALS**

VERFAHREN UND VORRICHTUNG ZUR ENTZERRUNG VON LINEAR VERZERRTEN SIGNALEN

PROCEDE ET APPAREIL DE CORRECTION DE SIGNAUX LINEAIREMENT DISTORDUS

(84) Designated Contracting States:
**AT BE CH CY DE DK ES FI FR GB GR IE IT LI LU
MC NL PT SE**

(43) Date of publication of application:
**12.03.2003 Bulletin 2003/11**

(73) Proprietor: **Siemens Mobile Communications
S.p.A.
20126 Milano (IT)**

(72) Inventor: **SCHMIDMAIER, Richard
D-80689 München (DE)**

(74) Representative: **Heusler, Wolfgang
v. Bezold & Sozien
Patentanwälte
Akademiestrasse 7
80799 München (DE)**

(56) References cited:
- **BOUDREAU D ET AL: "ADAPTIVE
  EQUALIZATION OF CPM SIGNALS
  TRANSMITTED OVER FAST
  RAYLEIGHFLAT-FADING CHANNELS" IEEE
  TRANSACTIONS ON VEHICULAR
  TECHNOLOGY,US,IEEE INC. NEW YORK, vol. 44,
  no. 3, 1 August 1995 (1995-08-01), pages 404-413,
  XP000526030 ISSN: 0018-9545**
- **GUERRE-CHALEY J F ET AL: "ETUDE DU
  SPECTROFILTRE ADAPTATIF MULTIVARIABLE
  AVEC FACTEUR D'OUBLI" TRAITEMENT DU
  SIGNAL,FR,CENTRALE DES REVUES,
  MONTROUGE, vol. 8, no. 3, 1991, pages 145-154,
  XP000309611 ISSN: 0765-0019**
- **NOLL T G: "DESIGN AND VERIFICATION OF A
  DIGITAL ADAPTIVE EQUALIZER ASIC"
  PROCEEDINGS OF THE INTERNATIONAL
  SYMPOSIUM ON CIRCUITS AND SYSTEMS,US,
  NEW YORK, IEEE, vol. CONF. 21, 7 June 1988
  (1988-06-07), pages 589-593, XP000119438 ISBN:
  951-721-239-9**

## Description

The present invention relates to a method and an apparatus to equalize linearly distorted signals by using an equalization filter.

To compensate for linear distortions, e.g. two-path fading, in QAM (quadrature amplitude modulated) systems usually LMS (least mean squares) equalizers are used. In some radio systems, a modulation format with constant envelope is used, e.g. CPM (continuous phase modulation), in order to be able to use inexpensive RF components. With this modulation, the transmitter amplifiers can be driven to the saturation point.

For the transmission of signals there exist standards which require a certain acceptance of linear distortions. Therefore, in some transmission systems, equalization is necessary.

In CPM systems, there is usually no decision in the I/Q (inphase and quadrature component) domain, but a processing in the phase domain. This has the advantage of a direct processing of the relevant information (the phase) in CPM, but the disadvantage that there do not exist decided I and Q symbols, so that a standard LMS equalizer as in the QAM case cannot be used.

The underlying task of the present invention is to create a method and an apparatus which allows the equalization of linearly distorted CPM signals. The said objectives are achieved by the features from claims 1 respectively 9. Further developments of the invention are characterized in additional claims.

In accordance with the invention, an adaptive filter is used as an equalization filter of CPM signals. The adaptation of its filter coefficients is based on instantaneous errors which are determined in the output signal of the filter. Furthermore, in order to stabilize the coefficients, the respective adaptation value of the filter coefficients will be driven back to a predetermined value with a defined time constant.

CPM is a modulation type with constant envelope. Since in the present invention only this signal property, namely the constant envelope, is used, the CMA (constant modulus algorithm) equalizer in accordance with the invention works advantageously independently from clock and carrier of the signal. The inherent tendency to instabilities of the fractionally spaced (T/2) equalizer is reduced substantially by the usage of a tap-leakage. Furthermore, the equalizer in accordance with the invention compensates also for I/Q-distortions (differences in orthogonality and gain) so that these settings need not be tuned in the demodulator.

The invention is described more detailed in the following figures and examples. It is shown:

Fig. 1     A principle schematic of the structure of a CPM system with the model of a two-path fading channel in order to explain an application of the invention;

Fig. 2     Basic principle of an equalizer;

Fig. 3     Diagram to illustrate the derivation of the instantaneous error used for the adaptation of the filter coefficients;

Fig. 4     Illustrative example for an error detector;

Fig. 5     Example for the structure of a correlator;

Fig. 6     Example of one of the components of the correlator according to Fig. 5;

Fig. 7     Example of a correlator cell to be used in the component according to Fig. 6;

Fig. 8, 9     Measured curves to illustrate the effectiveness of the invention.

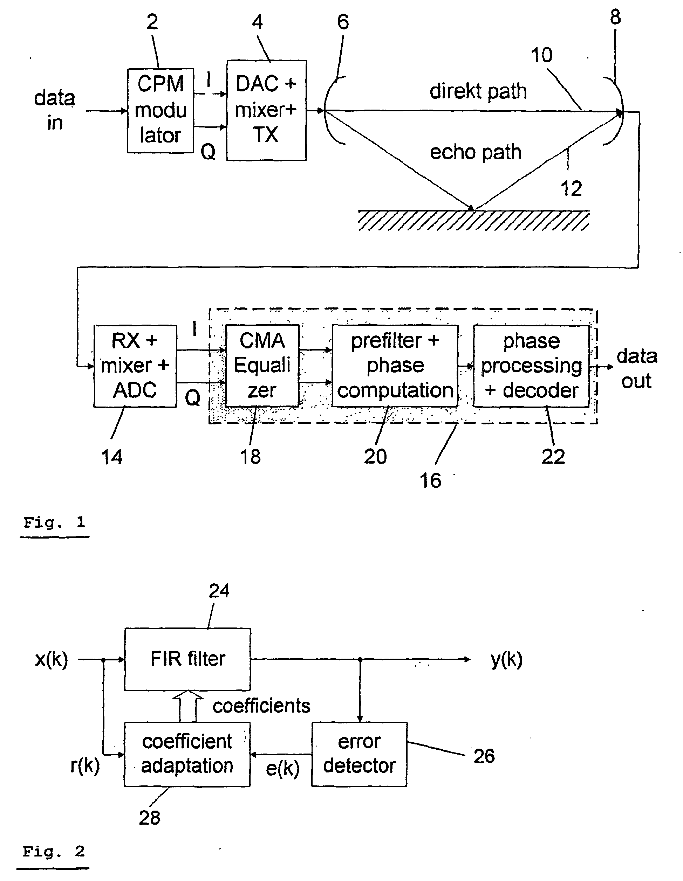

In the embodiment shown in Fig. 1, digital data samples are fed to the input of a modulator 2 which supplies CPM-modulated output signals to a transmitter 4 in which the digital CPM signals are converted into analog signals and modulated onto a carrier by an up-converter. This modulated RF signal *s(t)* is then fed to the transmit antenna 6 and sent to the receive antenna 8. The signal is propagated on a direct path 10 and indirectly on echo paths 12, of which only one is shown here representatively.

The received signals at the receive antenna 8 are fed to a receiver 14 which performs the down-conversion and A/D-conversion (analog-digital) of the signal. The receiver supplies output signals *x(t)* to a signal processing unit 16, which consists of an equalizer 18, a prefilter and phase detection unit 20 and a phase processing and decoding unit 22. At the output of the unit 16, the regenerated input data is present as output data.

Fig. 2 illustrates the basic principle of an equalizer (18). The signals *x(k)* which were distorted in the transmission channel are fed to a filter 24, which can for instance be implemented as an FIR filter with adjustable filter coefficients. Its output signals *y(k)* are fed to an error detector 26 which detects the instantaneous errors *e(k)* in the output signal and supplies them to a correlation and adaptation unit 28 which adjusts the coefficients of the FIR filter based on the errors *e(k)* and some reference signal *r(k)*, shown here to be the filter input signal. The unit 28 also makes sure that if there exist only small correlation contributions, the adapted filter coefficients return with a defined time constant to a predetermined value (tap leakage). This way, the signal equalization is performed based on the detected signal errors, hence in continuous adaptation to the transmission channel quality.

The cost function which is minimized by the CMA equalizer in accordance with the invention is:

$$J = E\left\{\left[|y(k)|^2 - 1\right]^2\right\}$$

Here, the mean output amplitude (the modulus) is normalized to 1 without restricting the invention.

The cost function becomes minimum when the deviation of the squared output amplitude from 1 is minimum. It is zero, when all complex output samples *y(k)* have the amplitude 1.

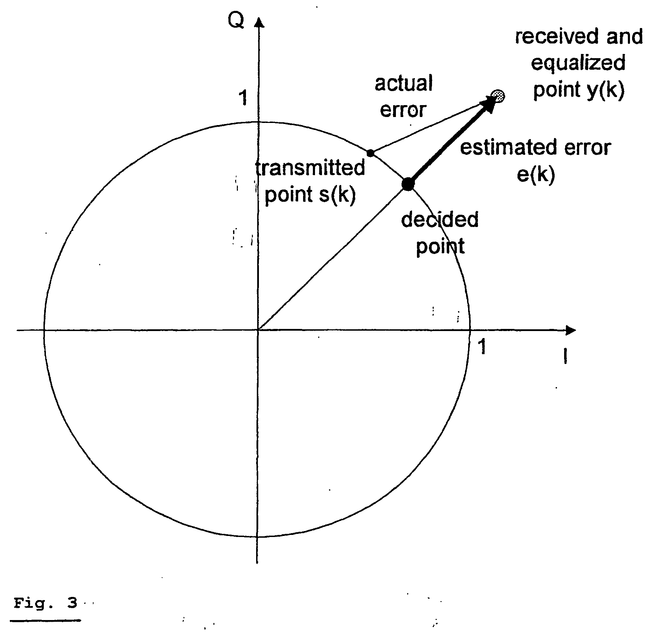

The adaptation algorithm defines an instantaneous error *e(k)* as the difference of the filter output signal value from its projection onto the unit circle, as it is shown in Fig. 3. It is therefore:

$$e(k) = \left\{|y(k)|^2 - 1\right\} \cdot y(k)$$

Unlike in QAM systems, the instantaneous error does not point to the correct direction, since only the radial component of the error can be determined. By the averaging done in the coefficient adaptation, however, the information about the direction (phase) of the error is obtained again.

The complex error has to be split into an I and Q part. With this instantaneous error then the correlation can be done as in a complex valued LMS equalizer following the "stochastic gradient descent":

$$C_i^{II}(k+1) = C_i^{II}(k) - \mu \cdot e^I(n+i) \cdot x^I(n)$$

$$C_i^{QI}(k+1) = C_i^{QI}(k) - \mu \cdot e^I(n+i) \cdot x^Q(n)$$

$$C_i^{IQ}(k+1) = C_i^{IQ}(k) - \mu \cdot e^Q(n+i) \cdot x^I(n)$$

$$C_i^{QQ}(k+1) = C_i^{QQ}(k) - \mu \cdot e^Q(n+i) \cdot x^Q(n)$$

where

$C_i^{II}(k)$        i-th equalizer coefficient in the II-rail at time instant k

$e^I(n)$     I-part of the instantaneous error at time instant n

$\mu$     step width

$x^I(n)$     Equalizer input signal at time instant n, channel I

As reported in literature (J. R. Treichler, V. Wolff, C. R. Johnson Jr., "Observed misconvergence in the constant modulus adaptive algorithm", *Conference Record of the Twenty-Fifth Asilomar Conference on Signals, Systems and Computers (Cat. No.91CH3112-0) IEEE Comput. Soc. Press: Los Alamitos*, 1991. p.663-7 vol.2), the CMA equalizer does not always converge to a solution which equalizes the input signal.

To solve this problem, in accordance with the invention a tap leakage is provided which causes a little deviation of the coefficients from their optimum values in the case of a distorting channel, but makes sure that with a flat channel, the coefficients do not diverge too much from their nominal position.

As already stated in the explanation of Fig. 3, the error $e(k)$ is detected by projection of the filter output signal onto the unit circle and splitting in I and Q parts. Since the filter output signal is already given in I and Q, the error can be directly calculated in I and Q:

$$e^I(k) = \left\{ |y(k)|^2 - 1 \right\} \cdot y^I(k)$$

$$e^Q(k) = \left\{ |y(k)|^2 - 1 \right\} \cdot y^Q(k)$$

To save word length, the multiplication can also be performed with the sign of $y^I$ respectively $y^Q$.

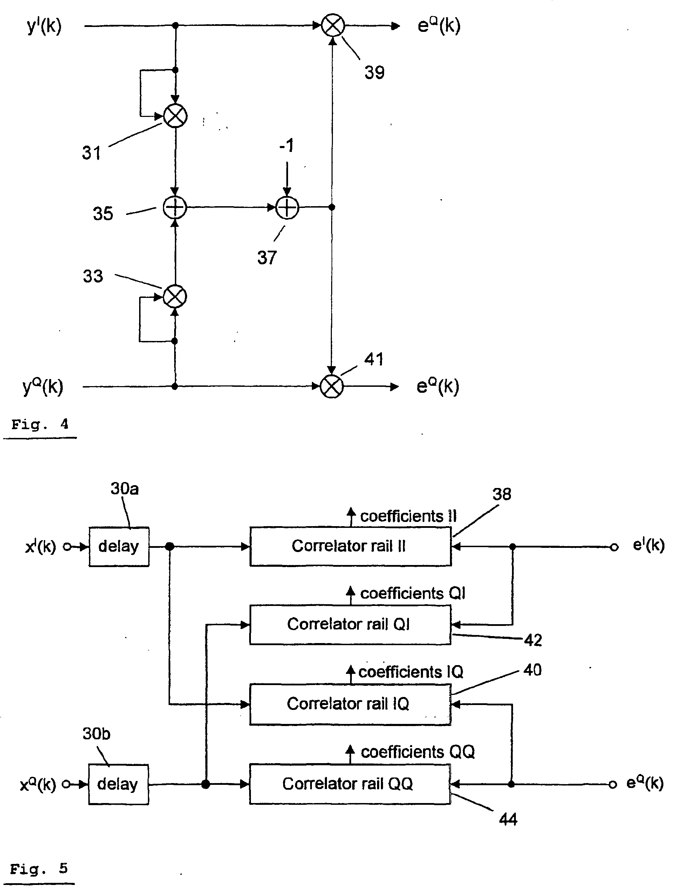

The structure of the error detector which implements the equations above for the case of a normalization of the output amplitude to 1 is shown in Fig. 4. The input signals $y^I(k)$ and $y^Q(k)$, respectively, are each fed to a squarer in the form of multipliers 31 and33, respectively. The squared signals are added in an adder 35. From this sum, a constant, here 1, is subtracted in another adder 37. The result is multiplied in two multipliers with the input signals $y^I(k)$and $y^Q(k)$, respectively, in order to form the instantaneous errors $e^I(k)$ and $e^Q(k)$, respectively.

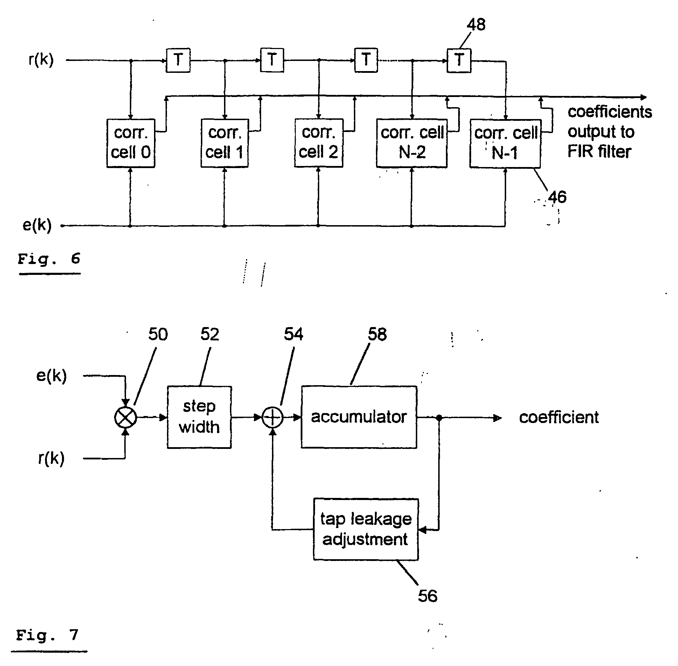

Let us now consider the adaptation of the coefficients. The coefficients are adapted by the correlation of a reference signal and an error signal. Fig. 5 and Fig. 6 show the upper level structure of the correlator, whereas Fig. 7 shows the details of a correlation cell.

According to Fig. 5, the I and Q samples of the reference signal input are fed to two delay units 30a and 30b in order to compensate for the basic delay of the filter 24. The output signals of unit 30a are supplied, as I reference values, to the first inputs of respective correlation units 38 and 40, whereas the output signals of unit 30b are supplied, as Q reference values, to the first inputs of respective correlation units 42' and 44. The second inputs of correlation units 38 and 42 have coupled thereto the I error signal, whereas the second inputs of correlation units 40 and 44 have coupled thereto the Q error signal. The structure of the correlation units follows Fig. 6. For an N-tap equalizer they consist in the illustrated manner of N correlation cells 46 and N-1 delay elements 48. By correlating reference values and error values, the coefficients for the filter 24 are adapted.

Fig. 7 shows the structure of a correlation cell 46. The error signal $e(k)$ and the reference signal $r(k)$ are multiplied in a multiplier 50. The resulting product is then amplified or attenuated in some unit 52. By an adder 54, a tap-leakage value is subtracted from this signal. The tap-leakage value is supplied by an adaptation unit 56 which adjusts the tap-leakage value, depending on the coefficient, to an appropriate value. The output signal of the adder 54 is then accumulated in a resettable accumulator 58 with saturation and supplied as coefficient to the filter 24.

As mentioned before, tap leakage makes the filter coefficients return to a predetermined value if there exist no or only small correlation contributions. It is achieved by a subtraction (adder 54) of a small part of the accumulator output value. If the leakage values lie e.g. in the order of $2^{-20}$, the accumulator word length can be still kept small when the tap leakage value is not subtracted in every cycle, but e.g. only every 16th cycle. In this case the accumulator can be shortened by 4 bits with respect to a solution with a subtraction every cycle.

It is desirable and necessary to achieve a stable behavior in the undistorted case, in which only the center tap should be different from zero and all other taps should have values close to zero, and also to obtain a sufficient equalization with a distorting channel. In order to achieve this, the tap leakage can be set differently for each tap.

The equalizer in accordance with the invention improves the system behavior mainly in two ways:

- It reduces the effects of two-path fadings (the signature area is reduced)

- It compensates for mistuning of the I/Q demodulator (90° phase, gain difference between I and Q)

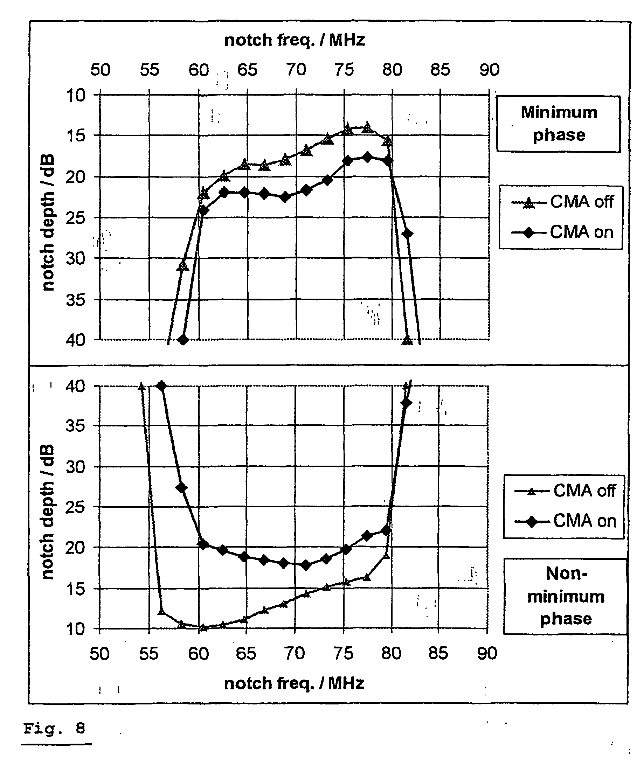

In Fig. 8, the improving effect of the equalizer to two-path fadings is shown in a signature measurement. Without equalizer the minimum signature depth is 10 dB, whereas with equalizer the minimum is increased to 18 dB.

The system parameters in this case are:

| $f_{BIT}$ = | 38.913 MHz |
| h (modulation index) = | 0.3 |
| $\tau$ (echo delay) = | 6.3 ns |

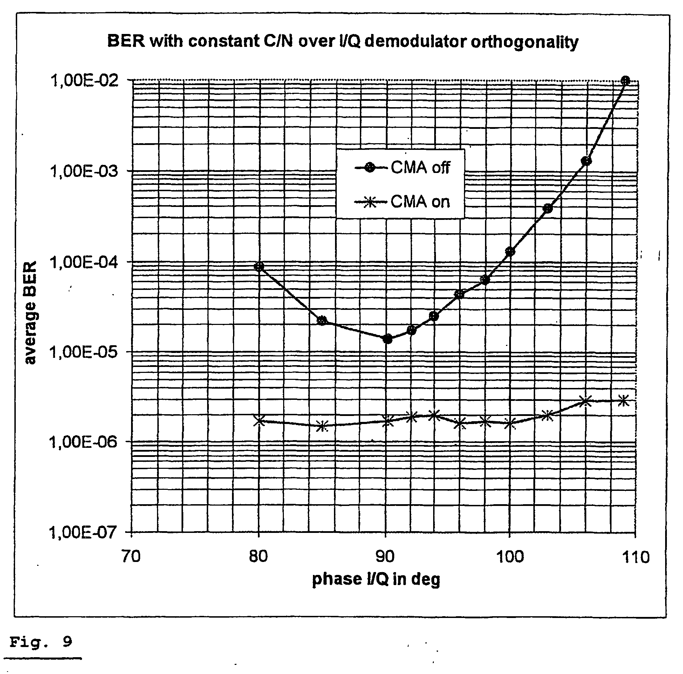

Fig. 9 shows the improving effect on demodulator mistuning: Errors in the 90° phase tuning of the I/Q demodulator or relative gain differences between I and Q normally cause a distortion of the received signal. A circle in the I/Q plane would be transformed to an ellipse. Without countermeasures, this results in a phase error leading to an increased bit error rate.

By implementing the CMA equalizer as a complex valued 4-rail equalizer, these distortions can be compensated for without any additional effort, by releasing one cross coefficient at the position 0 ($C^{IQ}(0)$ or $C^{QI}(0)$).

The measurement results in Fig. 9 illustrate that the CMA equalizer can compensate a phase error of $\pm 15°$ without substantial degradation. Since there is a direct relation between the gain difference and the phase error (a phase error of 15° corresponds to approximately 2.3 dB gain difference), the same holds accordingly for the compensation of I/Q gain differences.

## Claims

1.   Method for equalizing linearly distorted signals using an equalization filter, comprising

   - adaptive filtering of CPM modulated signals in order to equalize said signals;
   - by adapting the filter coefficients based on instantaneous errors e(k) derived from a decision of the filter output signal using a constant modulus criterion;
   - driving back of the coefficients to a predetermined value with a predetermined time constant.

2.   Method in accordance with claim 1, comprising

   - correlation of the instantaneous errors e(k) with a reference signal;
   - feeding of the correlation output signal to an accumulator which is used to form the filter coefficient;
   - and feeding-back of the accumulator output signal in order to drive the coefficient back to a predetermined value.

3.   Method in accordance with claim 2, in which the gain of the fed-back part of the accumulator output signal is adjusted differently for each coefficient.

4.   Method in accordance with claim 2, comprising the activation of the feed-back only every n-th cycle.

5.   Method in accordance with claim 2, in which said feed-back signal is a small part of the accumulator output signal and said feed-back signal is subtracted from the filter input signal.

6.   Method in accordance with claim 3, in which the filter (24) input signal is used as said reference signal.

7.   Method in accordance with claim 3, in which the filter (24) output signal is used as said reference signal.

8.   Apparatus for equalizing linearly distorted signals using an equalization filter, comprising, for processing transmitted CPM modulated signals,

   - an adaptive filter (24) whose coefficients are determined by some adaptation unit (28);
   - an error detector (26) connected to the filter output for generating, based upon the constant modulus criterion, an instantaneous error e(k) which is fed to an adaptation unit (26), and
   - means for driving the filter coefficients back to a predetermined value with a predetermined time constant.

9.   Apparatus in accordance with claim 8, comprising

   - a correlation unit for correlating the instantaneous errors e(k) with a reference signal;
   - an accumulator fed by the correlation output signal in order to form the filter coefficient;
   - means to feed back the accumulator output signal in order to drive the coefficient back to a predetermined value.

**10.** Apparatus in accordance with claim 9, in which the filter (24) input signal is said reference signal.

**11.** Apparatus in accordance with claim 9, in which said reference signal is the filter (24) output signal.

## Revendications

**1.** Procédé d'égalisation de signaux à distorsion linéaire utilisant un filtre d'égalisation, comprenant

- le filtrage adaptatif de signaux à modulation CPM pour égaliser lesdits signaux;
- l'adaptation des coefficients de filtrage sur la base des erreurs instantanées e(k) dérivées d'une décision du signal de sortie du filtre utilisant un critère de module constant;
- le retour des coefficients à une valeur prédéterminée avec une constante de temps prédéterminée.

**2.** Procédé selon la revendication 1, comprenant

- la corrélation des erreurs instantanées e(k) avec un signal de référence;
- l'alimentation du signal de sortie de corrélation dans un accumulateur qui est utilisé pour former le coefficient de filtrage;
- et le renvoi par rétroaction du signal de sortie d'accumulateur pour ramener le coefficient à une valeur prédéterminée.

**3.** Procédé selon la revendication 2, dans lequel le gain de la partie renvoyée par rétroaction du signal de sortie d'accumulateur est réglé de façon différente pour chaque coefficient.

**4.** Procédé selon la revendication 2, comprenant l'activation de la rétroaction seulement tous les n cycles.

**5.** Procédé selon la revendication 2, dans lequel ledit signal de rétroaction est une petite partie du signal de sortie d'accumulateur et ledit signal de rétroaction est soustrait du signal d'entrée de filtre.

**6.** Procédé selon la revendication 3, dans lequel le signal d'entrée du filtre (24) est utilisé comme dit signal de référence.

**7.** Procédé selon la revendication 3, dans lequel le signal de sortie du filtre (24) est utilisé comme dit signal de référence.

**8.** Appareil d'égalisation de signaux à distorsion linéaire utilisant un filtre d'égalisation, comprenant, pour le traitement des signaux à modulation CPM émis,

- un filtre adaptatif (24) dont les coefficients sont déterminés par une certaine unité d'adaptation (28);
- un détecteur d'erreur (26) relié à la sortie du filtre pour générer, sur la base du critère de module constant, une erreur instantanée e(k) qui est délivrée à une unité d'adaptation (28), et
- un moyen pour ramener les coefficients de filtrage à une valeur prédéterminée avec une constante de temps prédéterminée.

**9.** Appareil selon la revendication 8, comprenant

- une unité de corrélation pour corréler les erreurs instantanées e(k) avec un signal de référence;
- un accumulateur alimenté par le signal de sortie de corrélation afin de former le coefficient de filtrage;
- un moyen pour renvoyer par rétroaction le signal de sortie d'accumulateur afin de ramener le coefficient à une valeur prédéterminée.

**10.** Appareil selon la revendication 9, dans lequel le signal d'entrée du filtre (24) est ledit signal de référence.

**11.** Appareil selon la revendication 9, dans lequel ledit signal de référence est le signal de sortie du filtre (24).

## Patentansprüche

**1.** Verfahren zur Entzerrung linear verzerrter Signale unter Verwendung eines Entzerrungsfilters, mit

- adaptiver Filterung CPM-modulierter Signale zur Entzerrung der Signale;
- Adaptierung der Filterkoeffizienten aufgrund von momentanen Fehlern e(k), die aus dem Filterausgangssignal aufgrund einer Entscheidung unter Anwendung eines Konstant-Modulus-Kriteriums abgeleitet werden;
- Rückführung der Filterkoeffizienten mit einer vorbestimmten Zeitkonstante auf einen vorbestimmten Wert.

2. Verfahren nach Anspruch 1, bei dem

- die momentanen Fehler e(k) mit einem Referenzsignal korreliert werden;
- das Korrelationsausgangssignal einem Akkumulator zur Bildung des Filterkoeffizienten zugeführt wird;
- und das Ausgangssignal des Akkumulators zur Rückführung des Koeffizienten auf einen vorbestimmten Wert zurückgekoppelt wird.

3. Verfahren nach Anspruch 2, bei dem die Verstärkung des rückgekoppelten Anteils des Akkumulatorausgangssignals für jeden Filterkoeffizienten anders eingestellt wird.

4. Verfahren nach Anspruch 2, bei dem die Rückkopplung nur in jedem n-ten Zyklus erfolgt.

5. Verfahren nach Anspruch 2, bei dem das rückgekoppelte Signal ein kleiner Teil des Akkumulatorausgangssignals ist und von dem Filtereingangssignal subtrahiert wird.

6. Verfahren nach Anspruch 3, bei dem als Referenzsignal das Eingangssignal des Filters (24) benutzt wird.

7. Verfahren nach Anspruch 3, bei dem als Referenzsignal das Ausgangssignal des Filters (24) benutzt wird.

8. Vorrichtung zur Entzerrung linear verzerrter Signale unter Verwendung eines Entzerrungsfilters, enthaltend zur Verarbeitung übertragener CPM-modulierter Signale

- ein adaptives Filter (24), dessen Koeffizienten von einer Adaptionseinheit (28) bestimmt sind;
- einen mit dem Filterausgang verbundenen Fehlerdetektor (26) zur Erzeugung eines momentanen Fehlers e(k) aufgrund eines Konstant-Modulus-Kriteriums, der einer Adaptionseinheit (28) zugeführt wird, und
- eine Einrichtung, welche die Filterkonstanten mit einer vorbestimmten Zeitkonstante auf einen vorbestimmten Wert zurückführt.

9. Vorrichtung nach Anspruch 8, mit

- einer Korrelationseinheit zur Korrelierung des momentanen Fehlers e(k) mit einem Referenzsignal;
- einem Akkumulator, dem das Korrelator-Ausgangssignal zur Bildung des Filterkoeffizienten zugeführt wird;
- einer Einrichtung zur Rückführung des Akkumulatorausgangssignals, um die Koeffizienten auf einen vorbestimmten Wert zurückzubringen.

10. Vorrichtung nach Anspruch 9, in der das Referenzsignal durch das Eingangssignal des Filters (24) gebildet wird.

11. Vorrichtung nach Anspruch 9, in der das Referenzsignal durch das Ausgangssignals des adaptiven Filters (24) gebildet wird.

Fig. 1

Fig. 2

Fig. 3

$y^I(k)$ ⊗ $e^Q(k)$

39

31 ⊗

-1

35 ⊕ ⊕

37

33 ⊗

41

$y^Q(k)$ ⊗ $e^Q(k)$

Fig. 4

30a

coefficients II

38

$x^I(k)$ o→ delay → Correlator rail II ← o $e^I(k)$

coefficients QI

Correlator rail QI

42

coefficients IQ

40

Correlator rail IQ

coefficients QQ

30b

$x^Q(k)$ o→ delay → Correlator rail QQ ← o $e^Q(k)$

44

Fig. 5

r(k)

corr.
cell 0

corr.
cell 1

corr.
cell 2

corr. cell
N-2

corr. cell
N-1

48

coefficients
output to
FIR filter

46

e(k)

**Fig. 6**

e(k)

r(k)

50

52

step
width

54

58

accumulator

coefficient

tap leakage
adjustment

56

**Fig. 7**

Fig. 8

**BER with constant C/N over I/Q demodulator orthogonality**

Fig. 9